# EUROPEAN PATENT APPLICATION

(11) **EP 4 668 060 A1**
(43) Date of publication of application: **24.12.2025**
(21) Application number: 25183464.4
(22) Date of filing: 17.06.2025
(51) Int. Cl.: G06F 1/20, H01L 23/367, H01L 23/473, H05K 7/20

(54) **LIQUID-COOLED FLOW CHANNEL PLATE AND SUPERCOMPUTING DEVICE**

(30) Priority: 18.06.2024 CN 202421394913 U
(71) Applicant: Bitdeer Semiconductor Technology PTE. LTD., 049514 Singapore (SG)
(72) Inventor: YANG, SENFENG, 049514 Singapore (SG); LI, WEIGUO, 049514 Singapore (SG)
(74) Representative: Metida

(57) **Abstract**

Disclosed are a liquid-cooled flow channel plate and a supercomputing device. The liquid-cooled flow channel plate comprises a base plate and a cover plate. A plurality of sequentially communicated elongated slots that are juxtaposed are arranged in one surface of the base plate. A separating strip is formed between two adjacent elongated slots of the elongated slots. A free end of the separating strip is disposed at a junction between the two adjacent elongated slots. A flow guide structure is arranged at the junction, wherein the flow guide structure includes a flow guide pillar and a first flow guide plate. The flow guide pillar is disposed in an extension direction of the separating strip and is spaced apart from both the separating strip and a slot wall of the elongated slot where the flow guide pillar is disposed. The first flow guide plate is connected at least to one side of the flow guide pillar close to one of the elongated slots. A free end of the first flow guide plate extends towards the elongated slot on a side where the first flow guide plate is disposed. The cover plate is fitted onto the base plate and rests on the separating strip and the flow guide pillar, such that each of the elongated slots, together with a corresponding portion of the cover plate, forms a medium flow channel. According to the present disclosure, the uniformity of the flow velocity and temperature of a medium across a width direction of the flow channel is enhanced, and the structural strength and anti-noise capability of the liquid-cooled flow channel plate is improved.

## Description

### TECHNICAL FIELD

The present disclosure relates to the technical field of liquid cooling, and in particular, relates to a liquid-cooled flow channel plate and a supercomputing device.

### BACKGROUND

With the ever-increasing demands for data processing, supercomputing devices possessing ultra-high computing power have emerged. While these devices offer significant computation capabilities, the corresponding increase in computing power also leads to severe heat generation. If the heat is not dissipated effectively and promptly, adverse impacts may be caused to the performance and lifespan of hash chips (computing chips), or even device shutdowns or system crashes likely occur.

In conventional supercomputing devices, to enhance the heat dissipation efficiency, liquid cooling methods may be employed for some devices. However, the current liquid cooling flow channels often exhibit significant variations in cooling effectiveness across a width direction thereof. This results in inconsistent temperatures among the hash chips disposed along the width direction of the liquid cooling flow channels, particularly at the bends or junctions of these channels.

### SUMMARY

In view of the above situation, the present disclosure is mainly intended to provide liquid-cooled flow channel plate and a supercomputing device that may enhance the uniformity of flow velocity and temperature of a medium across a width direction of the flow channel, and enhance structural strength and anti-noise capabilities of the liquid-cooled flow channel plate, thereby improving temperature consistency (or uniformity) of chips at various locations across the width direction of the flow channel.

To achieve the above objective, the present disclosure employs the following technical solutions:

In one aspect, embodiments of the present disclosure provide a liquid-cooled flow channel plate for a supercomputing device, the supercomputing device including a hash board and the liquid-cooled flow channel plate, wherein the hash board includes hash chips, the hash chips being arranged in a plurality of rows on the hash board, the hash board being mounted on an outer surface of the liquid-cooled flow channel plate, and the hash chips being in contact with the outer surface; wherein the liquid-cooled flow channel plate includes a base plate and a cover plate, wherein a plurality of sequentially communicated elongated slots that are juxtaposed are arranged in one surface of the base plate, a separating strip being formed between two adjacent elongated slots of the elongated slots, a free end of the separating strip being disposed at a junction between the two adjacent elongated slots;
wherein a flow guide structure is arranged at the junction, the flow guide structure comprising a flow guide pillar and a first flow guide plate, wherein the flow guide pillar is disposed in an extension direction of the separating strip and is spaced apart from both the separating strip and a slot wall of the elongated slot where the flow guide pillar is disposed, the first flow guide plate is connected at least to one side of the flow guide pillar close to one of the elongated slots, and a free end of the first flow guide plate extends towards the elongated slot on a side where the first flow guide plate is disposed; and
wherein the cover plate is fitted onto the base plate and rests on the separating strip and the flow guide pillar, such that each of the elongated slots, together with a corresponding portion of the cover plate, forms a medium flow channel.

In some embodiments, the first flow guide plate is connected to both an upstream side and a downstream side of the flow guide pillar, and each of the first flow guide plates extends from the flow guide pillar towards an end, away from the flow guide pillar, of the elongated slot on a side where the first flow guide plate is disposed.

In some embodiments, a second flow guide plate is arranged on an outer side of the first flow guide plate, wherein the second flow guide plate is parallel to the first flow guide plate, and the first flow guide plate and the second flow guide plate divide the elongated slot where first flow guide plate and the second flow guide plates are disposed into three juxtaposed sub-flow channels.

In some embodiments, a length of the second flow guide plate is greater than a length of the first flow guide plate.

In some embodiments, the first flow guide plate and the second flow guide plate are disposed on both sides of the flow guide pillar, and a gap is defined between the two second flow guide plates.

In some embodiments, two flow guide surfaces of the first flow guide plate are both smooth convex curved surfaces, and both transition smoothly with the flow guide pillar.

In some embodiments, the first flow guide plate has a uniform wall thickness structure, and the flow guide pillar is a cylinder.

In some embodiments, the flow guide pillar is an elliptical cylinder.

In some embodiments, a first mounting hole is arranged in the separating strip, a second mounting hole is arranged in the flow guide pillar, and a third mounting hole corresponding to the first mounting hole and the second mounting hole is arranged in the cover plate.

In some embodiments, a positioning stud is arranged on both the separating strip and the flow guide pillar, wherein the first mounting hole and the second mounting hole are arranged in the positioning stud, and the third mounting hole is a positioning hole in positioning fit with a corresponding positioning stud.

In some embodiments, the liquid-cooled flow channel plate further includes heat dissipation fins; wherein the heat dissipation fins are disposed within each of the elongated slots, dividing the elongated slot into a plurality of sub-flow channels; the heat dissipation fins extend along an extension direction of the elongated slot where the heat dissipation fins are disposed and are spaced apart from the flow guide structure; and the base plate, each of the heat dissipation fins, and the first flow guide plate are all connected to the cover plate by brazing.

In some embodiments, each of the heat dissipation fins includes a plurality of sub-segments spaced apart along the extension direction of the elongated slot where the heat dissipation fins are disposed; each of the elongated slots is provided with a plurality of heat dissipation groups spaced apart in the extension direction of the elongated slot; and each of the heat dissipation groups includes a sub-segment from each of a plurality of heat dissipation fins that are juxtaposed.

In some embodiments, the first flow guide plate is connected on an upstream side of the flow guide pillar, and no first flow guide plate is disposed on a downstream side of the flow guide pillar; and each of the elongated slots includes a same number of the heat dissipation fins;
among the heat dissipation fins disposed on the upstream side of the flow guide pillar, a portion of the heat dissipation fins, designated as outer fins, are disposed radially outward of the first flow guide plate, wherein each of the outer fins extends beyond an upstream end of the first flow guide plate, and end portions of the outer fins are aligned; and a downstream end of each of remaining heat dissipation fins is spaced apart from the upstream end of the first flow guide plate; and
among the heat dissipation fins disposed on the downstream side of the flow guide pillar, a portion of the heat dissipation fins that are mirror-distributed relative to the outer fins about a center plane of the separating strip all extend beyond the free end of the separating strip, and end portion of the heat dissipation fins are aligned; and an upstream end of each of remaining heat dissipation fins is spaced at a distance from or is flush with the free end of the separating strip, and end portions of the remaining heat dissipation fins are aligned.

In a second aspect, embodiments of the present disclosure provide a supercomputing device. The supercomputing device includes a hash board and the liquid-cooled flow channel plate as described above; wherein the hash board includes hash chips, the hash chips being arranged in a plurality of rows on the hash board; and the hash board is mounted on an outer surface of the liquid-cooled flow channel plate, and the hash chips are in contact with a region on the liquid-cooled flow channel plate where the medium flow channels are disposed.

In some embodiments, at least some of the hash chips are disposed in a region on the liquid-cooled flow channel plate corresponding to the first flow guide plate.

In some embodiments, the hash chips in each of the rows are connected in series; a same one of the elongated slots corresponds to three rows of the hash chips; and each of the hash chips is in contact with the liquid-cooled flow channel plate via a thermally conductive material.

In the liquid-cooled flow channel plate according to the present disclosure, the flow guide pillar and the first flow guide plate are disposed at bends of the medium flow channel. Medium within the medium flow channel may flow past these bends along two flow guide surfaces of the first flow guide plate and the flow guide pillar. This reduces instances where the medium flow impacts the flow channel wall at the bends and where excessively abrupt changes in the flow direction generate bubbles. Consequently, this configuration minimizes a detrimental effect on heat transfer caused by bubble generation in the medium flow at the bends, thereby improving the flow uniformity throughout the medium flow channel and preventing excessive differences in medium flow rates between upstream and downstream sides of the bends. Therefore, it is ensured that the heat transfer effect of the medium flow is as consistent as possible across the width of the flow channel. When the liquid-cooled flow channel plate is used for dissipating heat from the hash chips, the heat dissipation for each hash chip disposed across the width of the flow channel is enabled to be as uniform as possible, such that the temperature consistency of the hash chips across the width is enhanced, the overall operational performance of the hash board is improved, and the service life of the hash board is extended. Furthermore, the flow guide pillar, by being set apart from the separating strip in the present disclosure, not only ensures that the flow cross-sectional area of the medium flow channel at the bends is substantially equal to that at other locations, but also provides support to the cover plate. This ensures the sealing integrity of the medium flow channels throughout, as well as enhancing the structural strength and anti-noise capability of the entire liquid-cooled flow channel plate.

Other beneficial effects of the present disclosure are described in retail with reference to specific technical features and technical solutions in the specific embodiments. A person skilled in the art may understand the beneficial effects achieved by these technical features and technical solutions through description of these technical features and technical solutions.

### BRIEF DESCRIPTION OF THE DRAWINGS

Some embodiments of the present disclosure are described with reference to accompanying drawings hereinafter.
FIG. 1 is a schematic structural view of a liquid-cooled flow channel plate according to some embodiments of the present disclosure;
FIG. 2 is an exploded view of a liquid-cooled flow channel plate according to some embodiments of the present disclosure;
FIG. 3 is a partial enlarged view of part I in FIG. 2;
FIG. 4 is a partial cross-sectional view of a liquid-cooled flow channel plate according to some embodiments of the present disclosure;
FIG. 5 is a front view of a base plate in a liquid-cooled flow channel plate according to some embodiments of the present disclosure;
FIG. 6 is a partial front view of a base plate in a liquid-cooled flow channel plate according to some embodiments of the present disclosure;
FIG. 7 is a partial front view of a base plate in a liquid-cooled flow channel plate according to some embodiments of the present disclosure; and
FIG. 8 is a partial front view of a base plate in a liquid-cooled flow channel plate according to some embodiments of the present disclosure.

Reference numerals and denotations thereof: 10-base plate; 11-elongated slot; 12-separating strip; 13-plate body; 14-annular rib; 15-medium inlet; 16-medium outlet; 17-positioning stud; 20-cover plate; 30-flow guide structure; 31-flow guide pillar; 32-first flow guide plate; 33-second flow guide plate; 40-heat dissipation fin; 41-sub-segment.

### DETAILED DESCRIPTION

The present disclosure is described with reference to some exemplary embodiments. However, the present disclosure is not limited to these exemplary embodiments. In the detailed description of the present disclosure, specific details are set forth. To avoid unnecessarily obscuring the substance of the present disclosure, well-known methods, procedures, processes, and components have not been described in detail.

Furthermore, it should be understood by persons of ordinary skill in the art that the drawings provided herein are for illustrative purposes only and are not necessarily drawn to scale.

Unless the context clearly requires otherwise, throughout this specification and the claims, the words "comprise," "contain," and the like are to be construed in an inclusive sense, as opposed to an exclusive or exhaustive sense, that is, in the sense of "including, but not limited to."

It should be noted that terms such as "first," "second," and the like are merely used for illustration purpose during the description of the present disclosure, and shall not be understood as indicating or implying relative importance. In addition, in the description of the present disclosure, the term "multiple," "more," or "a plurality of" refers to at least two unless otherwise specified.

Some embodiments of the present disclosure provide a liquid-cooled flow channel plate, which may be used for dissipating heat from components of electronic devices. Specifically, when used for a supercomputing device, the liquid-cooled flow channel plate dissipates heat from the components, namely hash chips, on a hash board (computing board) thereof. The supercomputing device includes a hash board and the liquid-cooled flow channel plate. The hash board includes hash chips, which are arranged in a plurality of rows on the hash board. The hash board is mounted on an outer surface of the liquid-cooled flow channel plate, and the hash chips are in contact with the outer surface.

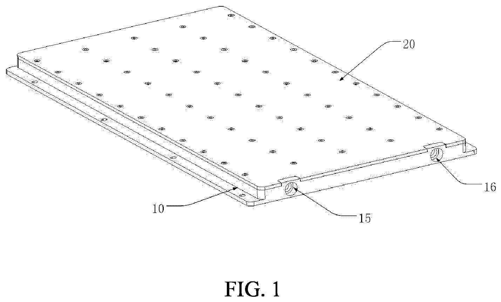

Referring to FIG. 1 to FIG. 8, the liquid-cooled flow channel plate includes a base plate 10 and a cover plate 20. A plurality of sequentially communicated elongated slots 11 that are juxtaposed are arranged in one surface of the base plate 10. A separating strip 12 is formed between two adjacent elongated slots 11, and a free end of the separating strip 12 is disposed at a junction between the two adjacent elongated slots 11. A flow guide structure 30 is arranged at the junction. The flow guide structure 30 includes a flow guide pillar 31 and a first flow guide plate 32. The flow guide pillar 31 is disposed in an extension direction of the separating strip 12 and is spaced apart from both the separating strip 12 and a slot wall of the elongated slot 11 where the flow guide pillar 31 is disposed. The first flow guide plate 32 is connected at least to one side of the flow guide pillar 31 close to one of the elongated slots 11, and a free end of the first flow guide plate 32 extends towards the elongated slot 11 on a side where the first flow guide plate 32 is disposed. The cover plate 20 is fitted onto the base plate 10 and rests on the separating strip 12 and the flow guide pillar 31. Each of the elongated slots 11, together with a corresponding portion of the cover plate 20, forms a medium flow channel.

In the liquid-cooled flow channel plate, the flow guide pillar 31 and the first flow guide plate 32 are disposed at bends of the medium flow channel. Medium within the medium flow channel may flow past these bends along two flow guide surfaces of the first flow guide plate 32 and the flow guide pillar 31. This reduces or even eliminates instances where the medium flow impacts the flow channel wall at the bends and where excessively abrupt changes in the flow direction generate bubbles. Consequently, this configuration minimizes a detrimental effect on heat transfer caused by bubble generation in the medium flow at the bends, thereby improving the flow uniformity throughout the medium flow channel and preventing excessive differences in medium flow rates between upstream and downstream sides of the bends. Therefore, it is ensured that the heat transfer effect of the medium flow is as consistent as possible across the width of the flow channel. When the liquid-cooled flow channel plate is used for dissipating heat from the hash chips, the heat dissipation for each hash chip disposed across the width of the flow channel is enabled to be as uniform as possible, such that the temperature consistency of the hash chips across the width is enhanced, the overall operational performance of the hash board is improved, and the service life of the hash board is extended. Furthermore, the flow guide pillar 31, by being set apart from the separating strip 12 in the present disclosure, not only ensures that the flow cross-sectional area of the medium flow channel at the bends is substantially equal to that at other locations, but also provides support to the cover plate 20. This ensures the sealing integrity of the medium flow channels throughout, as well as enhancing the structural strength and anti-noise capability of the entire liquid-cooled flow channel plate.

Specifically, the base plate 10 may include a plate body 13 and an annular rib 14. The annular rib 14 is connected to one surface of the plate body 13. The separating strip 12 is arranged within the annular rib 14, that is, both the separating strip 12 and the annular rib 14 are connected to the same surface of the plate body 13. One end of the separating strip 12 is connected to an inner wall of the annular rib 14, while the other end of the separating strip 12 is not connected to any part of the inner wall of the annular rib 14, thereby forming a free end. A plurality of separating strips 12 may be provided. These separating strips 12 divide a recessed area enclosed by the plate body 13 and the annular rib 14 into the plurality of elongated slots 11 that are communicated with each other. In a case where the liquid-cooled flow channel plate has a substantially rectangular cuboid structure, the annular rib 14 may have a rectangular ring-shaped structure. The separating strip 12 may be connected to one short side of the rectangular ring-shaped structure, with the free end thereof spaced apart from the other short side. In a case where a plurality of separating strips 12 are provided, two adjacent separating strips 12 may be connected to different short sides respectively. Furthermore, a medium inlet 15 and a medium outlet 16 may be arranged in the short sides. The medium inlet 15 and the medium outlet 16 are in communication with two ends of the medium flow channel.

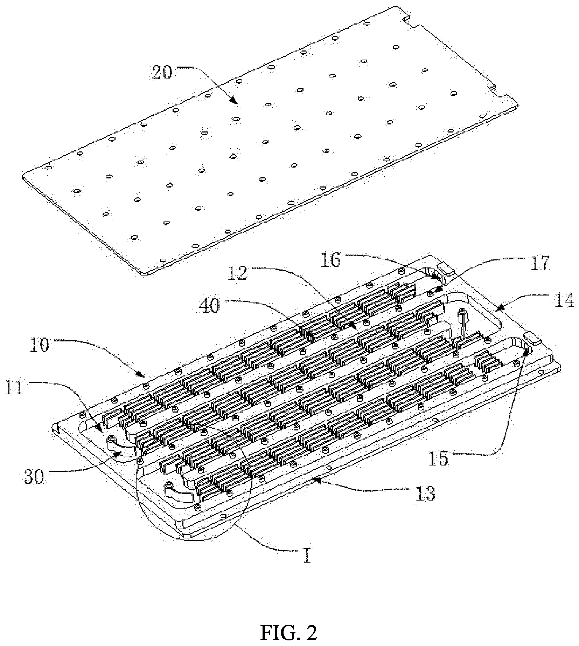

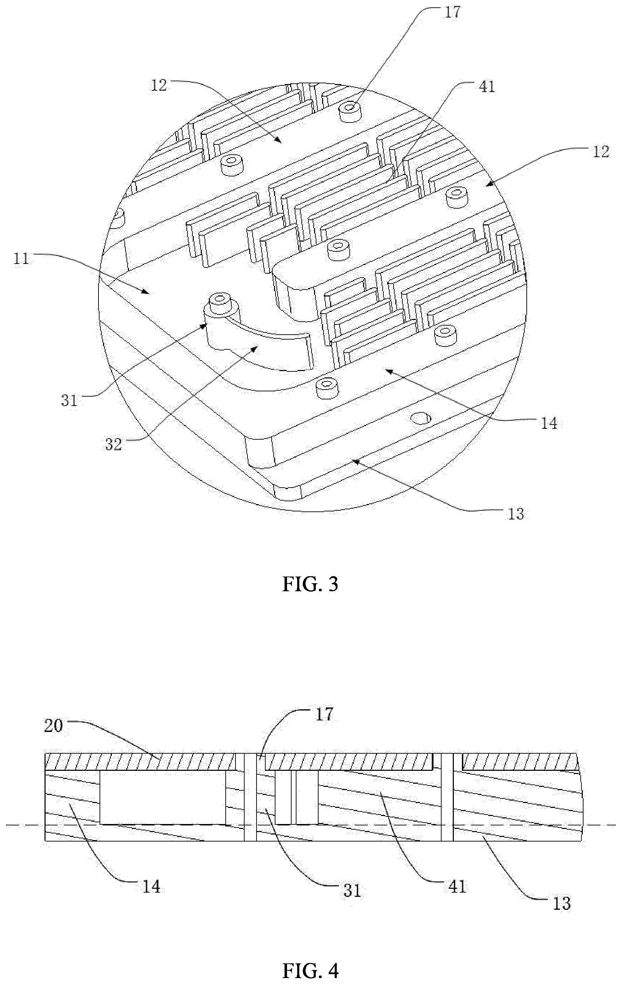

Still referring to FIG. 2 and FIG. 3, the flow guide pillar 31 may be a cylinder, an elliptical cylinder, a free-form surface pillar, or other pillar-like structures, as long as the flow guide surface formed by the side surface of the flow guide pillar achieves a flow guide effect. In a case where the flow guide pillar 31 is a cylinder, the side surface thereof is a cylindrical surface. Adopting this cylindrical structure helps to increase the strength of the flow guide pillar 31, facilitate manufacturing, and also enhance the flow guide effect of the flow guide pillar 31. In a case where the flow guide pillar 31 is an elliptical cylinder, the side surface thereof is an elliptical cylindrical surface. In a case where the flow guide pillar 31 is a free-form surface pillar, the side surface thereof is a free-form surface. Using such an elliptical cylinder structure, the guide effect of the flow guide pillar 31 on the medium is extended, thereby increasing the flow velocity of the medium at the bends.

The two flow guide surfaces of the first flow guide plate 32 are mutually parallel, that is, the first flow guide plate has a uniform wall thickness structure. This configuration enhances the consistency of the flow velocity and temperature of the medium across the width of the flow channel at the bends (i.e., at the junction of the two elongated slots 11).

Specifically, the first flow guide plate 32 is a smooth convex curved panel, and two flow guide surfaces thereof are both smooth convex curved surfaces. For example, the first flow guide plate 32 may be an arc-shaped plate, a parabolic panel, a free-form curved panel, or various other types of curved panels. In a case where the first flow guide plate 32 is an arc-shaped plate, both guide surfaces are arc-shaped surfaces; in a case where the first flow guide plate 32 is a parabolic panel, both guide surfaces are parabolic surfaces; and in a case where the first flow guide plate 32 is a free-form curved panel, both guide surfaces are free-form curved surfaces. In some embodiments, the first flow guide plate 32 is an arc-shaped plate, which may be a circular arc plate or an elliptical arc plate, and is further preferably a circular arc plate. This configuration better enhances the flow guide effect of the entire flow guide structure, and prevents the medium from directly impacting the inner wall of the medium flow channel and generating bubbles, thereby further improving the heat dissipation performance of the entire liquid-cooled flow channel plate.

Furthermore, the two flow guide surfaces of the same first flow guide plate 32 transition smoothly at the ends thereof. That is, the first flow guide plate 32 has an end face connecting the two flow guide surfaces, and this end face is a smooth convex curved surface. This means that the two flow guide surfaces and the end face are smoothly connected. The ends of the two flow guide surfaces on the same side (i.e., the free end) form a non-sharp-angled structure, and the two flow guide surfaces are also not connected by a plane perpendicular to these two flow guide surfaces (i.e., a plane perpendicular to the tangent planes of these two flow guide surfaces). By using the first flow guide plate 32 according to the embodiments, the guide effect on the medium at the bends is further enhanced.

It should be noted that the flow guide structure 30 may be formed by a combination of any of the above-described structures for the flow guide pillar 31 and the first flow guide plate 32. For example, the first flow guide plate 32 may have a uniform wall thickness structure, and the flow guide pillar 31 may be a cylinder. Still for example, the first flow guide plate 32 may adopt any of the above-described structures, while the flow guide pillar 31 is an elliptical cylinder.

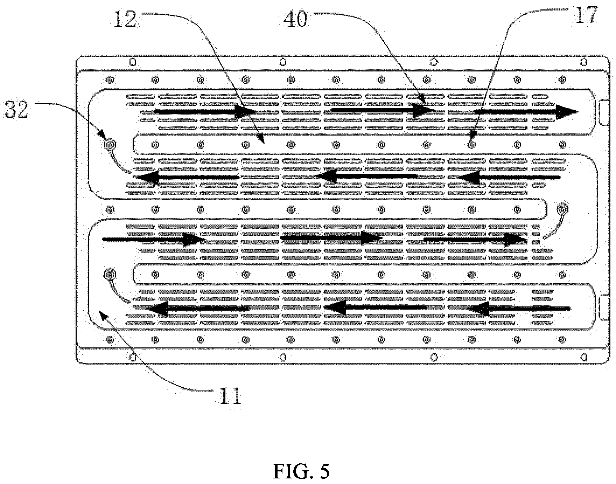

The two sides of the flow guide pillar 31 respectively refer to a side thereof radially close to an upstream elongated slot 11 and a side thereof close to a downstream elongated slot 11. As illustrated in FIG. 5 to FIG. 8, among two connected elongated slots 11, the one disposed on an upstream side may be designated as an upstream flow channel, and the one disposed on a downstream side may be designated as a downstream flow channel. Then, a first side of the flow guide pillar 31 refers to a side in an upstream flow channel region, and a second side refers to a side in a downstream flow channel region.

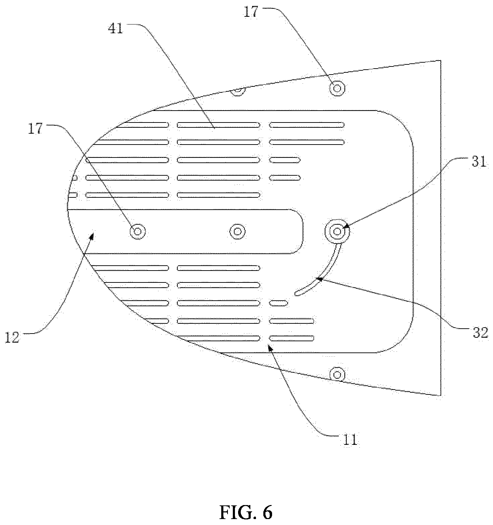

In some embodiments, as illustrated in FIG. 5 and FIG. 6, the first flow guide plate 32 is disposed only on one side of the flow guide pillar 31. For instance, the first flow guide plate 32 may be disposed only on the upstream side (i.e., the first side) of the flow guide pillar 31. A first end of the first flow guide plate 32 is connected to the flow guide pillar 31, and a second end is a free end. In the direction of the medium flow, the second end is closer than the first end to an upstream end of the upstream elongated slot 11 (i.e., the upstream flow channel). In some embodiments, the first flow guide plate 32 may be disposed only on the downstream side (i.e., the second side) of the flow guide pillar 31. A first end of the first flow guide plate 32 is connected to the flow guide pillar 31, and a second end is a free end. In the direction of the medium flow, the second end is closer than the first end to a downstream end of the downstream elongated slot 11 (i.e., the downstream flow channel).

Still referring to FIG. 5 and FIG. 6, the first flow guide plate 32 is connected on the upstream side of the flow guide pillar 31, and no first flow guide plate 32 is disposed on the downstream side thereof. Each of the elongated slots 11 includes the same number of heat dissipation fins. Among the heat dissipation fins disposed on the upstream side of the flow guide pillar 31 (i.e., the heat dissipation fins disposed in a lower flow channel in FIG. 6), a portion thereof, designated as outer fins, are disposed radially outward of the first flow guide plate 32; each of the outer fins extends beyond an upstream end of the first flow guide plate 32, and their ends are aligned. A downstream end of each of the remaining heat dissipation fins 40 is spaced apart from the upstream end of the first flow guide plate 32. When projected along a width direction of the elongated slot 11 (i.e., perpendicular to an extension direction of the elongated slot 11 or, in other words, perpendicular to an extension direction of the separating strip), a projection of the first flow guide plate 32 and a projection of the outer fins have an overlapping region. Among the heat dissipation fins 40 disposed on the downstream side of the flow guide pillar 31, a portion of the heat dissipation fins 40 that are mirror-distributed relative to the outer fins about a center plane of the separating strip 12 all extend beyond the free end of the separating strip 12, and end portions of the heat dissipation fins 40 are aligned. An upstream end of each of the remaining heat dissipation fins 40 is spaced at a distance from, or is flush with, the free end of the separating strip 12, and end portions of the heat dissipation fins 40 are aligned. That is, in FIG. 6, among the heat dissipation fins 40 disposed in an upper flow channel, the upper plurality of heat dissipation fins 40 (the two heat dissipation fins disposed in an upper part of the upper elongated slot in the drawings) extend beyond the free end of the separating strip 12, while the lower heat dissipation fins 40 (the two heat dissipation fins disposed in a lower part of the upper elongated slot in the figure) do not extend beyond the free end of the separating strip 12, or are flush with the free end of the separating strip, or are spaced apart from the free end of the separating strip 12. With the arrangement between the flow guide structure 30 and the adjacent heat dissipation fins thereof, the guide effect on the medium at the bends is further enhanced, the flow rate difference of the medium between the upstream and downstream elongated slots at the bends is reduced, and hence the consistency of heat dissipation throughout the entire liquid-cooled flow channel plate is further improved.

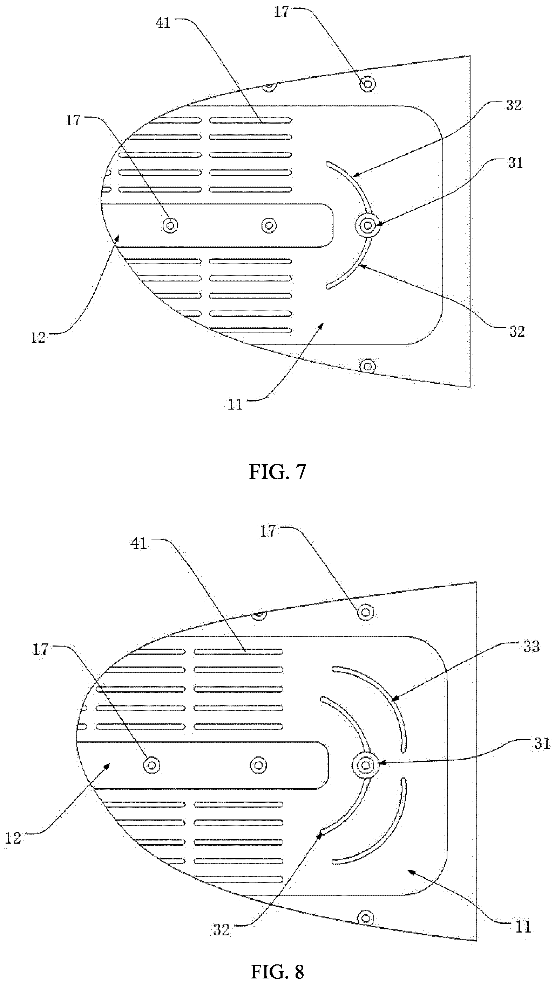

In some embodiments, the first flow guide plate 32 is connected to both the upstream side and the downstream side of the flow guide pillar 31, and each of the first flow guide plates 32 extends towards an end, away from the flow guide pillar 31, of the elongated slot 11 on a side where the first flow guide plate 32 is disposed. As illustrated in FIG. 7, the flow guide structure 30 includes two first flow guide plates 32. The two first flow guide plates 32 are disposed on two sides of the flow guide pillar 31. That is, one first flow guide plate 32 is connected to the upstream side (the first side) of the flow guide pillar 31, wherein a first end of the first flow guide plate 32 is connected to the flow guide pillar 31, and a second end (i.e., the free end) of the first flow guide plate 32 extends towards the upstream end of the elongated slot 11 (i.e., the upstream flow channel) wherein the first flow guide plate 32 is disposed; and another first flow guide plate 32 is connected to the downstream side (i.e., the second side) of the flow guide pillar 31, wherein a first end of the first flow guide plate 32 is connected to the flow guide pillar 31, and a second end (i.e., the free end) of the first flow guide plate 32 extends towards a downstream end of the elongated slot 11 (i.e., the downstream flow channel) where the first flow guide plate 32 is disposed. By disposing the first flow guide plates 32 on both sides of the flow guide pillar 31, the length of the flow guide path provided by the flow guide structure 30 for the medium is extended, such that a better flow guide effect is achieved. This, in turn, ensures that the medium still achieves a stable velocity at the bends of the medium flow channel, improves the consistency of velocity and temperature across the width of the medium flow channel at these locations, and further enhances the heat dissipation performance of the entire liquid-cooled flow channel plate.

In some embodiments, the flow guide structure 30 further includes a second flow guide plate 33. The second flow guide plate 33 and the first flow guide plate 32 at the same location are juxtaposed along the width direction of the medium flow channel. That is, the second flow guide plate 33 is arranged on the outer side of the first flow guide plate 32, and the second flow guide plate 33 and the first flow guide plate 32 are arranged in parallel, and the two flow guide plates divide the elongated slot 11 where these plates are disposed into three sub-flow channels that are juxtaposed. For example, as illustrated in FIG. 8, the first flow guide plate 32 and the second flow guide plate 33 are arranged on the same side of the flow guide pillar 31. In this configuration, the first flow guide plate 32 and the second flow guide plate 33 are spaced apart from each other in the width direction of the medium flow channel at this location and are parallel to each other, thereby dividing the medium flow channel into three sub-flow channels. Furthermore, the flow cross-sectional areas of these three sub-flow channels are substantially equal. This configuration further enhances the flow uniformization effect across the width of the medium flow channel at this location, and hence improves the consistency of flow velocity and temperature of the medium in the width direction of the medium flow channel.

Specifically, the first flow guide plate 32 and the second flow guide plate 33 may be simultaneously disposed only on one side of the flow guide pillar 31. For example, the first flow guide plate 32 and the second flow guide plate 33 are simultaneously disposed only on the upstream side of the flow guide pillar 31, or the first flow guide plate 32 and the second flow guide plate 33 are simultaneously disposed only on the downstream side of the flow guide pillar 31. In some embodiments, the first flow guide plate 32 and the second flow guide plate 33 are arranged on both sides of the flow guide pillar 31, and a gap is provided between the two second flow guide plates 33, that is, the two second flow guide plates 33 are not connected and are disposed on two sides of the flow guide pillar 31. By simultaneously arranging the first flow guide plate 32 and the second flow guide plate 33 on both sides of the flow guide pillar 31, the flow guide effect at the bends of the medium flow channel is further enhanced. Moreover, the spaced arrangement of the two second flow guide plates 33 prevents turbulence at the bends, which might otherwise be caused by an overly long path of the flow guide structure. This, in turn, further improves the consistency of the flow velocity and temperature of the medium at these locations, and increases the heat dissipation performance of the entire liquid-cooled flow channel plate.

For the structure of the second flow guide plate 33, reference may be made to the structure of the first flow guide plate 32. The two flow guide surfaces, end face, and the manner of connection between the two flow guide surfaces and the end face may all adopt the configuration regarding the first flow guide plate 32, which is thus not described herein any further. It should be noted that the first flow guide plate 32 and the second flow guide plate 33 may be configured with different lengths or the same length. Preferably, the length of the first flow guide plate 32 is less than the length of the second flow guide plate 33, to increase the guide effect path on the radially outer side at the bends, and further enhance the flow guide effect at these locations.

Still referring to FIG. 2 and FIG. 3, the liquid-cooled flow channel plate further includes heat dissipation fins 40. The heat dissipation fins 40 are arranged within each of the elongated slots 11, which divide the elongated slot 11 into a plurality of sub-flow channels. The heat dissipation fins 40 extend along an extension direction of the elongated slot 11 where the heat dissipation fins 40 are disposed, and are spaced apart from the flow guide structure 30. That is, each of the heat dissipation fins 40 is spaced apart from the flow guide pillar 31 and the first flow guide plate 32. In embodiments where the second flow guide plate 33 is provided, each of the heat dissipation fins 40 is also spaced apart from the second flow guide plate 33. By disposing the heat dissipation fins 40 within the elongated slots 11, the heat dissipation fins 40 exerts a compressive (or squeezing) effect on the medium, such that the flow velocity of the medium is increased. Furthermore, by defining a space between the heat dissipation fins 40 and the flow guide pillar 31 and the first flow guide plate 32, turbulence at the bends is avoided while the flow velocity is increased. This further enhances the consistency of the flow velocity and temperature of the medium, and increases the overall heat dissipation performance of the liquid-cooled flow channel plate.

The heat dissipation fins 40 have an elongated plate-like structure. Within each elongated slot 11, two, three, or more heat dissipation fins 40 may be juxtaposed. As illustrated in FIG. 2 and FIG. 3, five heat dissipation fins 40 are juxtaposed in the width direction of the flow channel within each elongated slot 11. Each of a space between two adjacent heat dissipation fins 40 in the width direction, a space between the innermost heat dissipation fin 40 and the corresponding side wall of the elongated slot 11 where the innermost heat dissipation fin 40 is disposed, and a space between the outermost heat dissipation fin 40 and the corresponding side wall of the elongated slot 11 where the outermost heat dissipation fin 40 disposed forms a sub-flow channel.

The plurality of elongated slots 11 may be arranged parallel to each other, i.e., juxtaposed along respective width directions thereof. Respective flow cross-sectional areas of the elongated slots are equal, and the flow cross-sectional area at the bends of the medium flow channel is also substantially equal to the flow cross-sectional area of other sections.

Each of the heat dissipation fins 40 within the elongated slot 11 may be a single uninterrupted strip disposed along the entire region of the elongated slot 11 in an extension direction thereof, or may be a plurality of sub-segments arranged discontinuously. That is, each of the heat dissipation fins 40 includes a plurality of sub-segments 41 spaced apart along the extension direction of the elongated slot 11 where the heat dissipation fin 40 is disposed. Each of the elongated slots 11 is provided with a plurality of heat dissipation groups spaced apart in an extension direction thereof, and each of the heat dissipation groups includes a sub-segment 41 from each of the plurality of heat dissipation fins 40 that are juxtaposed. As illustrated in FIG. 2 and FIG. 3, in the same elongated slot 11, the plurality of sub-segments 41 from different heat dissipation fins 40 form a plurality of heat dissipation groups, and each of the heat dissipation groups includes one sub-segment 41 from different heat dissipation fins 40. By using a plurality of spaced-apart sub-segments, the occurrence of turbulence in the elongated slot 11 is further avoided, enhancing the heat dissipation performance and anti-noise capability of the entire medium flow channel.

In some embodiments, a first mounting hole is arranged in the separating strip 12, a second mounting hole is arranged in the flow guide pillar 31, and the cover plate 20 is mounted onto the base plate 10 via the first mounting hole and the second mounting hole. That is, the first mounting hole and the second mounting hole are respectively arranged in the separating strip 12 and the flow guide pillar 31, and a third mounting hole corresponding to the first mounting hole and the second mounting hole is arranged in the cover plate 20. In a case where the cover plate 20 is fitted onto the base plate 10, the first mounting hole, the second mounting hole, and the third mounting hole are correspondingly aligned. By adopting this structure, the flow guide pillar 31 is reused as a mounting structure for the cover plate 20 and the base plate 10. This avoids an excessive reduction in the flow cross-sectional area at the bends that might occur where the separating strip 12 is extended. In this way, the flow cross-sectional area of the medium flow channel at the bends is relatively increased, and the overall space utilization of the liquid-cooled flow channel plate is enhanced.

Furthermore, a positioning pin 17 is arranged on both the separating strip 12 and the flow guide pillar 31. The first mounting hole and the second mounting hole are arranged in the positioning stud 17, and the third mounting hole is a positioning hole in positioning fit with a corresponding positioning stud. With the positioning studs and the positioning holes, the positioning accuracy between the cover plate 20 and the base plate 10 is enhanced, thereby enhancing the positioning accuracy of the entire liquid-cooled flow channel plate with other components, for example, the hash board. The first mounting hole and the second mounting hole may be used to further enhance the connection reliability between the cover plate 20 and the base plate 10. In embodiments where a hash board (described in detail hereinafter) is arranged on a side of the cover plate 20 facing away from the base plate 10, the hash board may also be directly engaged with the first mounting hole and the second mounting hole by means of fastening members passing through the third mounting hole, thereby facilitating the mounting of the hash board.

Referring to FIG. 1 to FIG. 4, the flow guide structure 30 and the heat dissipation fins 40 may be integrally formed with the base plate 10, and thereafter, the cover plate 20 is fitted and connected thereto. Both the flow guide structure 30 and the heat dissipation fins 40 are sealingly abutted against the cover plate 20. The cover plate 20 and the base plate 10 may be directly sealingly connected, for example, by means of a sealing strip and screw fastening. In some embodiments, the cover plate 20 and the base plate 10 are connected by brazing. Specifically, the base plate 10, each of the heat dissipation fins 40, and the first flow guide plate 32 are all connected to the cover plate 20 by brazing. In embodiments where the second flow guide plate 33 is provided, the second flow guide plate 33 is also brazed to the cover plate 20. By adopting this configuration, solder may fill the gaps between the base plate 10, the flow guide structure 30, the heat dissipation fins 40, and the cover plate 20, thereby enhancing the sealing integrity throughout the medium flow channels.

Some embodiments of the present disclosure further provide a supercomputing device. The supercomputing device includes the liquid-cooled flow channel plate according to any one of the above embodiments.

The supercomputing device further includes a hash board. The hash board includes hash chips. The hash chips are arranged in a plurality of rows on the hash board. The hash board is mounted on the outer surface of the liquid-cooled flow channel plate, and the hash chips are in contact with a region on the liquid-cooled flow channel plate where the medium flow channels are disposed. At least some of the hash chips are disposed in a region on the liquid-cooled flow channel plate corresponding to the first flow guide plate 32. By adopting this arrangement, the heat dissipation efficiency of the liquid-cooled flow channel plate for the hash board is improved. Specifically, the hash board may be mounted on a side of the cover plate 20 facing away from the base plate 10, or on a side of the base plate 10 facing away from the cover plate 20, or the hash board may be mounted on both sides of the liquid-cooled flow channel plate.

The hash chips in each of the rows are connected in series, and a same one of the elongated slots 11 corresponds to three rows of hash chips. That is, a region of the same elongated slot 11 corresponding to the outer surface of the liquid-cooled flow channel plate is simultaneously in contact with the three rows of hash chips, and hence the heat dissipation efficiency of the liquid-cooled flow channel plate for the hash board is improved.

Furthermore, each of the hash chips may be in contact with the liquid-cooled flow channel plate via a thermally conductive material, such that the heat transfer effect between the hash chips and the liquid-cooled flow channel plate is enhanced. The thermally conductive material may include any one of, or a combination of: a thermal grease, a thermal gel, or a thermal pad.

A person skilled in the art would understand that the above technical solutions may be freely combined and superimposed as long as no conflicts exist.

It should be understood that the above embodiments are only exemplary, and construe no limitations. Under the circumstance of not departing from the basic principles of the present disclosure, various obvious or equivalent modifications or substitutions that persons skilled in the art may derive to the above-described details are all included within the scope of the claims of the present disclosure.

## Claims

1. A liquid-cooled flow channel plate for a supercomputing device, the supercomputing device comprising a hash board and the liquid-cooled flow channel plate, wherein the hash board comprises hash chips, the hash chips being arranged in a plurality of rows on the hash board, the hash board being mounted on an outer surface of the liquid-cooled flow channel plate, and the hash chips being in contact with the outer surface; wherein the liquid-cooled flow channel plate comprises a base plate and a cover plate, wherein a plurality of sequentially communicated elongated slots that are juxtaposed are arranged in one surface of the base plate, a separating strip being formed between two adjacent elongated slots of the elongated slots, a free end of the separating strip being disposed at a junction between the two adjacent elongated slots;
wherein a flow guide structure is arranged at the junction, the flow guide structure comprising a flow guide pillar and a first flow guide plate, wherein the flow guide pillar is disposed in an extension direction of the separating strip and is spaced apart from both the separating strip and a slot wall of the elongated slot where the flow guide pillar is disposed, the first flow guide plate is connected at least to one side of the flow guide pillar close to one of the elongated slots, and a free end of the first flow guide plate extends towards the elongated slot on a side where the first flow guide plate is disposed; and
wherein the cover plate is fitted onto the base plate and rests on the separating strip and the flow guide pillar, such that each of the elongated slots, together with a corresponding portion of the cover plate, forms a medium flow channel.

2. The liquid-cooled flow channel plate according to claim 1, wherein the first flow guide plate is connected to both an upstream side and a downstream side of the flow guide pillar, and each of the first flow guide plates extends from the flow guide pillar towards an end, away from the flow guide pillar, of the elongated slot on a side where the first flow guide plate is disposed.

3. The liquid-cooled flow channel plate according to claim 1, wherein a second flow guide plate is arranged on an outer side of the first flow guide plate, wherein the second flow guide plate is parallel to the first flow guide plate, and the first flow guide plate and the second flow guide plate divide the elongated slot where first flow guide plate and the second flow guide plates are disposed into three juxtaposed sub-flow channels.

4. The liquid-cooled flow channel plate according to claim 3, wherein a length of the second flow guide plate is greater than a length of the first flow guide plate.

5. The liquid-cooled flow channel plate according to claim 3, wherein the first flow guide plate and the second flow guide plate are disposed on both sides of the flow guide pillar, and a gap is defined between the two second flow guide plates.

6. The liquid-cooled flow channel plate according to claim 1, wherein two flow guide surfaces of the first flow guide plate are both smooth convex curved surfaces, and both transition smoothly with the flow guide pillar.

7. The liquid-cooled flow channel plate according to claim 1, wherein the first flow guide plate has a uniform wall thickness structure, and the flow guide pillar is a cylinder.

8. The liquid-cooled flow channel plate according to claim 1, wherein the flow guide pillar is an elliptical cylinder.

9. The liquid-cooled flow channel plate according to claim 1, wherein a first mounting hole is arranged in the separating strip, a second mounting hole is arranged in the flow guide pillar, and a third mounting hole corresponding to the first mounting hole and the second mounting hole is arranged in the cover plate.

10. The liquid-cooled flow channel plate according to claim 9, wherein a positioning stud is arranged on both the separating strip and the flow guide pillar, wherein the first mounting hole and the second mounting hole are arranged in the positioning stud, and the third mounting hole is a positioning hole in positioning fit with a corresponding positioning stud.

11. The liquid-cooled flow channel plate according to any one of claims 1 to 10, further comprising: heat dissipation fins; wherein the heat dissipation fins are disposed within each of the elongated slots, dividing the elongated slot into a plurality of sub-flow channels; the heat dissipation fins extend along an extension direction of the elongated slot where the heat dissipation fins are disposed and are spaced apart from the flow guide structure; and the base plate, each of the heat dissipation fins, and the first flow guide plate are all connected to the cover plate by brazing.

12. The liquid-cooled flow channel plate according to claim 11, wherein each of the heat dissipation fins comprises a plurality of sub-segments spaced apart along the extension direction of the elongated slot where the heat dissipation fins are disposed; each of the elongated slots is provided with a plurality of heat dissipation groups spaced apart in the extension direction of the elongated slot; and each of the heat dissipation groups comprises a sub-segment from each of a plurality of heat dissipation fins that are juxtaposed.

13. The liquid-cooled flow channel plate according to claim 11, wherein the first flow guide plate is connected on an upstream side of the flow guide pillar, and no first flow guide plate is disposed on a downstream side of the flow guide pillar; and each of the elongated slots comprises a same number of the heat dissipation fins;
among the heat dissipation fins disposed on the upstream side of the flow guide pillar, a portion of the heat dissipation fins, designated as outer fins, are disposed radially outward of the first flow guide plate, wherein each of the outer fins extends beyond an upstream end of the first flow guide plate, and end portions of the outer fins are aligned; and a downstream end of each of remaining heat dissipation fins is spaced apart from the upstream end of the first flow guide plate; and
among the heat dissipation fins disposed on the downstream side of the flow guide pillar, a portion of the heat dissipation fins that are mirror-distributed relative to the outer fins about a center plane of the separating strip all extend beyond the free end of the separating strip, and end portions of the heat dissipation fins are aligned; and an upstream end of each of remaining heat dissipation fins is spaced at a distance from or is flush with the free end of the separating strip, and end portions of the remaining heat dissipation fins are aligned.

14. A supercomputing device, comprising: a hash board and the liquid-cooled flow channel plate as defined in any one of claims 1 to 13; wherein the hash board comprises hash chips, the hash chips being arranged in a plurality of rows on the hash board; and the hash board is mounted on an outer surface of the liquid-cooled flow channel plate, and the hash chips are in contact with a region on the liquid-cooled flow channel plate where the medium flow channels are disposed.

15. The supercomputing device according to claim 14, wherein at least some of the hash chips are disposed in a region on the liquid-cooled flow channel plate corresponding to the first flow guide plate;
wherein the hash chips in each of the rows are connected in series; a same one of the elongated slots corresponds to three rows of the hash chips; and each of the hash chips is in contact with the liquid-cooled flow channel plate via a thermally conductive material.
